(19) Europäisches Patentamt
European Patent Office
Office européen des brevets

(11) Publication number : **0 473 401 A2**

(12) # EUROPEAN PATENT APPLICATION

(21) Application number : **91307854.9**

(22) Date of filing : **28.08.91**

(51) Int. Cl.[5] : **C01G 3/00,** C04B 35/00, H01L 39/12

(30) Priority : **29.08.90 JP 227240/90**

(43) Date of publication of application : **04.03.92 Bulletin 92/10**

(84) Designated Contracting States : **DE FR GB**

(71) Applicant : **NATIONAL RESEARCH INSTITUTE FOR METALS**
**2-3-12, Nakameguro**
**Meguro-ku Tokyo (JP)**

(71) Applicant : **KYORITSU CERAMIC MATERIALS CO., LTD**
**No. 41, 2-Chome Tsukisan-cho, Minato-Ku**
**Nagoya, Aichi (JP)**

(72) Inventor : **Kaieda, Yoshinari, c/o Nat. Res. Inst. for Metals**
**2-3-12, Nakameguro**
**Meguro-Ku, Tokyo (JP)**
Inventor : **Otaguchi, Minoru, c/o Nat. Res. Inst. for Metals**
**2-3-12, Nakameguro**
**Meguro-Ku, Tokyo (JP)**
Inventor : **Oguro, Nobutaka, c/o Nat. Res. Inst. for Metals**
**2-3-12, Nakameguro**
**Meguro-Ku, Tokyo (JP)**
Inventor : **Oiye, Tadashi, c/o Kyoritsu Ceramic Mat. Co., Ltd.**
**No. 41, 2-Chome, Tsukisan-Cho**
**Minato-Ku, Nagoya (JP)**

(74) Representative : **Holmes, Michael John**
**Frank B. Dehn & Co. Imperial House 15-19 Kingsway**
**London WC2B 6UZ (GB)**

(54) **Method of manufacturing oxide superconductive material.**

(57) A method of manufacturing an oxide superconductive material, which permits improvement of superconductivity, and simple and easy manufacture of an oxide superconductive material. The method comprises the steps of using pure copper powder and gaseous oxygen, mixing pure copper powder and powder of pure metals or compounds of other component elements, introducing external heat input to part of the powder mixture of raw materials, causing synthetic reaction by the heat of formation generated from combustion reaction between pure copper powder and gaseous oxygen, and causing propagation of the synthetic reaction throughout the entire powder mixture of raw materials by self-propagating high-temperature synthesis.

EP 0 473 401 A2

The present invention relates to a method of manufacturing an oxide superconductive material. More particularly, the present invention relates to a method of manufacturing an oxide superconductive material, having an improved superconductivity, by a simple and easy method.

For lanthanum, yttrium, bismuth and thallium type oxide superconductive materials, it is the conventional practice in general to use powdery compounds such as an oxide, a carbonated compound or a nitrated compound containing prescribed elements as the raw materials, to mix these powdery raw materials at prescribed blending ratios, and to synthesize an oxide superconductive material by repeating a cycle comprising calcining, grinding, forming and full sintering for a long period of time.

When manufacturing an oxide superconductive material consisting of only a high-temperature phase of high critical temperature by this conventional method, it is necessary to repeat a long cycle of processes.

In the conventional method as described above, however, the blending ratio of powdery raw materials, even if accurately set initially, tends to deviate from the initial setting through repetition of grinding and long sintering during the manufacturing process. This finally results in the deviation of the elementary ratios of the superconductive material, and the product cannot in many cases perform as intended as an oxide superconductive material.

The present invention provides a method of manufacturing an oxide superconductive material containing copper and oxygen as the component elements, comprising the steps of using pure copper powder and gaseous oxygen, mixing pure copper powder and powder of pure metals or compounds of other component elements, introducing external heat input to part of the powder mixture of raw materials, causing synthetic reaction by the heat of formation generated from combustion reaction between pure copper powder and gaseous oxygen, and causing propagation of the synthetic reaction throughout the entire powder mixture of raw materials by self-propagating high-temperature synthesis, thereby manufacturing an oxide superconductive material.

In the accompanying drawings:

Fig. 1 is a sectional view illustrating an embodiment of an apparatus according to the present invention;

Figs. 2(a), (b), (c) and (d) are sectional views illustrating examples of the container for the powder mixture of raw materials;

Fig. 3 is a sectional view illustrating the state of propagation of the synthetic reaction and heat in the powder mixture of raw materials; and

Figs. 4, 5 and 6 are diagrams illustrating the relationship between temperature and magnetic susceptibility and electric resistivity of yttrium, bismuth and thallium oxide superconductive materials manufactured by the method of the present invention.

In the method of manufacturing an oxide superconductive material of the present invention, the heat of formation from the combustion reaction between pure copper powder and gaseous oxygen as shown by the following formulae is used:

$$Cu + 0.5O_2 \rightarrow CuO + 155.0 \text{ kJ/mol}$$
$$2Cu + 0.5O_2 \rightarrow Cu_2O + 167.2 \text{ kJ/mol}$$

Either of these reactions generates heat of approximately 160 kJ/mol. This heat is utilized in the method of the present invention to cause self-propagating high-temperature synthesis.

When synthesizing a lanthanum, yttrium, bismuth or thallium type oxide superconductive material, partial ignition or overall heating of the powder mixture of raw materials containing substantially pure copper powder at a prescribed temperature such as room temperature in oxygen gas or a mixed gas of oxygen gas and an inert gas causes combustion of pure copper powder and gaseous oxygen at a portion having a particularly increased temperature (hot spot). At the same time, the heat of formation of this combustion reaction heats the adjacent portions, further causing combustion of pure copper powder and gaseous oxygen. The heat of this combustion causes reactions with the other powdery raw materials, thereby causing the synthesis of an oxide superconductive material. These series of reactions gradually propagate in succession, thus converting the entire sample into a synthetic product, i.e. a phenomenon known as self-propagating high-temperature synthesis.

The principle of this self-propagating high-temperature synthetic reaction is expressed in the following formulae:

$$0.5Y_2O_3 + 2BaO + 3Cu \xrightarrow{\text{in } O_2} YBa_2Cu_3O_7$$

$$0.5Y_2O_3 + 2BaO + 4Cu \xrightarrow{\text{in } O_2} YBa_2Cu_4O_8$$

$$Bi_2O_3 + 2SrCO_3 + 2CaCO_3 + 3Cu \xrightarrow{\text{in } O_2} Bi_2Sr_2Ca_2Cu_3O_{10} + 4CO_2$$

$$Bi_2O_3 + 2SrCO_3 + CaCO_3 + 2Cu \xrightarrow{\text{in } O_2} Bi_2Sr_2CaCu_2O_8 + 3CO_2$$

$$0.5Tl_2O + 2BaO + 2CaCO_3 + 3Cu \xrightarrow{\text{in } O_2} TlBa_2Ca_2Cu_3O_9 + 2CO_2$$

$$0.5Tl_2O + 2BaO + 3CaCO_3 + 4Cu \xrightarrow{\text{in } O_2} TlBa_2Ca_3Cu_4O_{11} + 3CO_2$$

The self-propagating high-temperature synthetic reaction in the present invention was found by the present inventors to have the following phenomena and effects:

[1] The self-propagating rate, varying with filling density of the powder mixture of raw materials and oxygen partial pressure, is generally within a range of from 1 cm/min to several tens of cm/min. Even for a powder of the order of a few hundred grams, therefore, synthesis is completed in a short period of time of several tens of seconds to a few minutes. As compared with the conventional method, as a result, it is possible to largely save time and energy, and even when the synthetic reaction is incomplete under some conditions, it is possible to reduce the tine required for various subsequent processes such as calcining or sintering.

[2] In an oxide superconductive material, the oxygen content is known to exert an important effect on superconductivity. That is, lack of oxygen reduces the superconductive critical temperature (Tc) and inhibits realization of a high-temperature phase. However, by causing self-propagating high-temperature synthesis while sufficiently supplying oxygen into the powder mixture of raw materials, oxygen deficiencies is no longer caused, but it is possible to manufacture an oxide superconductive material containing sufficient oxygen.

[3] Since, in the conventional method, the cycle comprising calcining, grinding and mixing is repeated, the blending ratios of the component elements set initially gradually vary and the final chemical composition deviates from the prescribed value. However, the self-propagating high-temperature synthesis permits synthesis in a very short period of time and manufacture of an oxide superconductive material with an accurately adjusted chemical composition.

In manufacturing an oxide superconductive material according to the present invention, a selection is made from among lanthanum, yttrium, bismuth and thallium type oxide superconductive materials and powdery raw materials are accurately weighed so as to achieve the prescribed chemical composition. For elements other than copper and oxygen, appropriate material. such as substantially pure metals, oxides, carbonated compounds or nitrated compounds may be employed. Pure (ie. substantially pure) copper powder should be used as copper. Pure copper powder will preferably have a content of oxygen and other impurities of up to 3% and an average powder particle size of up to 50 μm. Oxygen should be gaseous oxygen which should be in the form of pure oxygen gas or a mixed gas of oxygen gas and an inert gas such as argon, nitrogen, helium or neon.

The weighed powdery raw materials are sufficiently mixed in an appropriate mixer such as a ball mill or a mortar. Subsequently, as shown in Fig. 1, for example, a container (2) is filled with powder mixture of raw materials (1), and this container (2) is inserted into an electric furnace (4) in a high-pressure vessel (3). In the apparatus as shown in Fig. 1, the high-pressure vessel (3) is sealed with a high-pressure sealing mechanism (5). An electrode (9) necessary for a heater (6) of the electric furnace (4), a resistance heating wire (7) for ignition, a temperature measuring thermocouple (8) etc. are pulled out through the wall while maintaining the airtightness of the high-pressure vessel (3) so as to allow necessary operations from outside. A vacuum

evacuation system (10) and a high-pressure source (11) of pure oxygen gas or a mixed gas of oxygen gas and an inert gas are connected to the bottom of the apparatus. As the container (2), in order to supply full oxygen in the raw materials (1), it is desirable to use, corresponding with oxygen partial pressure, for example, as shown in Fig. 2 (a), (b), (c) and (d), a refractory crucible, a permeable refractory crucible or a refractory net made of stainless steel or other similar material (2a), a crucible (2b) having the bottom consisting of stainless steel or other refractory net or permeable ceramic material, or a refractory horizontal crucible (2c) or a U-shaped crucible (2d). Although elements other than oxygen are present in the form of powder in the synthetic reaction portion in necessary amounts, oxygen which is introduced in gaseous form has such a low density that oxygen is always scarce in the synthetic reaction portion unless oxygen is used under a very high pressure. Any of the above-mentioned containers may be used to ensure sufficient supply of oxygen in a necessary amount during synthetic reaction. When employing a refractory crucible, a permeable refractory crucible or a refractory net (2a) made of stainless steel or other similar material for example, oxygen can be fed in from the side and the bottom of the crucible or the net to the powdery raw materials (1). For a crucible (2b) with the bottom consisting of a stainless steel refractory net or permeable ceramic material, oxygen can be supplied from the bottom. In the case of a refractory horizontal crucible (2c), the sufficiently large upper area of the powder mixture of raw materials (1) permits sufficient supply of oxygen from the top of the horizontal crucible (2c). For a U-shaped crucible (2d), oxygen can be fed through the powder mixture of raw materials (1) from the end furthest from the ignition point such as a resistance heating wire (7) for ignition.

The possible modes of ignition include, in addition to heating by a resistance heating wire (7) such as a nichrome wire as shown in fig. 1, use of electric energy such as an electric arc. Spontaneous ignition through heating of the entire powder mixture of raw materials (1) in the electric furnace (4) may also be adopted.

That is, the electric furnace (4) as shown in Fig. 1 is not always necessary, but is used when the entire powder mixture of raw materials (1) is heated without using the resistance heating wire (7) to cause spontaneous ignition starting from a portion whose temperature becomes particularly high (hot spot). It is also applicable when manufacturing a superconductive material at a temperature higher than room temperature.

Thus, the furnace as the means for heating in this case is not limited to an electric furnace (4), but any appropriate means may be adopted.

When using a resistance heating wire (7) for ignition, the resistance heating wire (7) is brought into contact with or close to an end of the powder mixture of raw materials (1).

After evacuating the high-pressure vessel (3) using a vacuum evacuation system (10), pure oxygen gas or a mixed gas of oxygen and an inert gas is introduced under a prescribed pressure from the high-pressure gas source (11). The gas pressure should preferably be higher than 0.1 $kg/cm^2$ in absolute pressure. In an absolute gas pressure within a range from 0.1 $kg/cm^2$ to approximately 150 $kg/cm^2$, the gas may be introduced directly from a high-pressure gas bomb, for example. For a higher pressure than the above-mentioned range, the pressure may be increased by means of a compressor.

The synthetic reaction is initiated by applying a current of several Amps to several tens of Amps to the resistance heating wire (7) for ignition, or producing an electric arc, or heating an end of the powder mixture of raw materials (1) by means of the electric furnace (4), for example.

The process of this synthetic reaction is illustrated in Fig. 3.

As shown in Fig. 3, in the powder mixture of raw materials ignited by the resistance heating wire (7) for ignition, for example, combustion synthetic reaction of oxygen and copper forms a compound (1a), and simultaneously, reaction heat of formation is generated in a large quantity in the reaction zone (1b), heating the adjacent portions (1c) into heating zones, propagating the synthetic reaction. The reaction process caused by this self-propagating high-temperature synthetic reaction propagates from an end of the powder mixture of raw materials (1) to the other end in the arrow direction as in Fig. 3, converting the unreacting portions (1d) totally into a compound. The entire powder mixture of raw materials (1) is synthesized into an oxide superconductive material.

Upon cooling of the synthetic product to a prescribed temperature after the completion of these series of synthetic reactions, the interior of the high-pressure vessel (3) as shown in Fig. 1 is restored to the atmospheric pressure and released, and the synthesized oxide superconductive material is removed together with the container (2).

Now, the oxide superconductive material manufactured by the present invention is illustrated in more detail by means of the following examples.

[Manufacture of yttrium type oxide superconductive material]

Example 1

Raw materials other than oxygen were mixed at accurate blending ratios so as to give $YBa_2Cu_3O_7$, and the resultant mixture was subjected to self-propagating high-temperature synthesis at room temperature in pure oxygen gas under an absolute pressure of 0.5 kg/cm$^2$. Pure copper powder containing 1% impurities (oxygen: 0.5%) and having a particle size of 5 μm was employed. A net made of stainless steel was used as a container, and filled with the powder mixture of raw materials in an amount of 100 g. Ignition was performed by producing an electric arc between the upper portion of the powder mixture of raw materials and the electrode through application of voltage of 30,000 V.

Investigation of the synthesized powder for superconductivity showed a superconductive critical temperature (Tc) of approximately 80 K. The powder was fully sintered at a temperature of 930°C for 15 hours without grinding and calcination, resulting in a superconductive critical temperature (Tc) of 93 K.

EXAMPLE 2

Raw materials were mixed at the same blending ratios as in Example 1, and subjected to self-propagating high-temperature synthesis at room temperature in pure oxygen gas under an absolute pressure of 1 kg/cm$^2$. Powder containing 1% impurities (oxygen: 0.5%) and having a particle size of 0.3 μm, and a crucible made of permeable ceramics were employed. The crucible was filled with the powder mixture of raw materials in an amount of 100 g. Ignition was performed by producing an electric arc between the upper portion of the powder mixture of raw materials and the electrode through application of voltage of 30,000 V.

Investigation of the synthesized powder for superconductivity showed a superconductive critical temperature (Tc) of approximately 80 K. The powder was fully sintered at a temperature of 930°C for 15 hours without grinding and calcination, resulting in a superconductive critical temperature (Tc) of 93 K.

EXAMPLE 3

The same powder mixture of raw materials as in Example 1 was used, and subjected to self-propagating high-temperature synthesis at room temperature in pure oxygen gas under an absolute pressure of 2 kg/cm$^2$. A crucible made of permeable ceramics was employed and filled with the powder mixture of raw materials in an amount of 100 g. Ignition was performed by bringing a nichrome wire formed into a coil shape closer to the upper portion of the powder mixture of raw materials and heating it through energizing.

Investigation of the synthesized powder for superconductivity showed a superconductive critical temperature (Tc) of approximately 80 K. The powder was fully sintered at a temperature of 930°C for 15 hours without grinding and calcination, resulting in a superconductive critical temperature (Tc) of 93 K.

EXAMPLE 4

The same powder mixture of raw materials as in Example 2 was used, and subjected to self-propagating high-temperature synthesis at room temperature in pure oxygen gas under an absolute pressure of 5 kg/cm$^2$. A refractory crucible with a bottom made of a stainless steel net was employed, and filled with the powder mixture of raw materials in an amount of 100 g. Ignition was performed by using an electric furnace in a high-pressure vessel and heating the entire powder mixture of raw materials.

Investigation of the synthesized powder for superconductivity showed a superconductive critical temperature (Tc) of approximately 90 K.

EXAMPLE 5

The same powder mixture of raw materials as in Example 1 was used, and subjected to self-propagating high-temperature synthesis at room temperature in pure oxygen gas under an absolute pressure of 10 kg/cm$^2$. A refractory crucible with the bottom made of a stainless steel net was employed, and filled with the powder mixture of raw materials in an amount of 100 g. Ignition was performed by bringing a nichrome wire formed into a coil shape closer to the upper portion of the powder mixture of raw materials and heating it through energizing.

Investigation of the synthesized powder for superconductivity showed a superconductive critical temperature (Tc) of approximately 80 K. The powder was fully sintered at a temperature of 930°C for 15 hours without

grinding and calcination, resulting in a superconductive critical temperature (Tc) of 93 K.

EXAMPLE 6

The same powder mixture of raw materials as in Example 2 was used, and subjected to self-propagating high-temperature synthesis at room temperature in pure oxygen gas under an absolute pressure of 20 $kg/cm^2$. A horizontal refractory crucible was employed, and filled with the powder mixture of raw materials in an amount of 100 g. Ignition was performed by bringing a nichrome wire formed into a coil shape closer to the upper portion of the powder mixture of raw materials and heating it through energizing.

Investigation of the synthesized powder for superconductivity showed a superconductive critical temperature (Tc) of approximately 80 K. The powder was fully sintered at a temperature of 930°C for 15 hours without grinding and calcination, resulting in a superconductive critical temperature (Tc) of 93 K.

EXAMPLE 7

The same powder mixture of raw materials as in Example 1 was used, and subjected to self-propagating high-temperature synthesis at room temperature in pure oxygen gas under an absolute pressure of 50 $kg/cm^2$. A refractory U-shaped crucible was employed, and filled with the powder mixture of raw materials in an amount of 100 g. Ignition was performed by bringing a nichrome wire formed into a coil shape closer to the upper portion of the powder mixture of raw materials and heating it through energizing.

Investigation of the synthesized powder for superconductivity showed a superconductive critical temperature (Tc) of approximately 93 K.

EXAMPLE 8

The same powder mixture of raw materials as in Example 2 was used, and subjected to self-propagating high-temperature synthesis at room temperature in pure oxygen gas under a pressure of 100 $kg/cm^2$. A crucible made of permeable ceramics was employed, and filled with the powder mixture of raw materials in an amount of 100 g. Ignition was performed by bringing a nichrome wire formed into a coil shape closer to the upper portion of the powder mixture of raw materials and heating it through energizing.

Investigation of the synthesized powder for superconductivity showed a superconductive critical temperature (Tc) of approximately 93 K as shown in Fig. 4.

EXAMPLE 9

The same powder mixture of raw materials as in Example 1 was used, and subjected to self-propagating high-temperature synthesis at room temperature in pure oxygen gas under an absolute pressure of 300 $kg/cm^2$. A crucible made of permeable ceramics was employed, and filled with the powder mixture of raw materials in an amount of 100 g. Ignition was performed by bringing a nichrome wire formed into a coil shape closer to the upper portion of the powder mixture of raw materials and heating it through energizing.

Investigation of the synthesized powder for superconductivity showed a superconductive critical temperature (Tc) of approximately 93 K.

EXAMPLE 10

The same powder mixture of raw materials as in Example 1 was used, and subjected to self-propagating high-temperature synthesis at room temperature in a mixed gas of pure oxygen gas and argon gas under an absolute pressure of 1,000 $kg/cm^2$ (oxygen partial pressure: 400 $kg/cm^2$). A crucible made of permeable ceramics was employed, and filled with the powder mixture of raw materials in an amount of 100 g. Ignition was performed by bringing a nichrome wire formed into a coil shape closer to the upper portion of the powder mixture of raw materials and heating it through energizing.

Investigation of the synthesized powder for superconductivity showed a superconductive critical temperature (Tc) of approximately 93 K.

EXAMPLE 11

Raw materials other than oxygen were mixed at accurate blending ratios so as to give $YBa_2Cu_4O_8$, and the resultant mixture was subjected to self-propagating high-temperature synthesis at room temperature in a

mixed gas of pure oxygen and argon gas under an absolute pressure of 1,000 kg/cm$^2$ (oxygen partial pressure: 200 kg/cm$^2$). A crucible made of permeable ceramics was employed, and filled with the powder mixture of raw materials in an amount of 300 g. Ignition was performed by bringing a nichrome wire formed into a coil shape closer to the upper portion of the powder mixture of raw materials and heating it through energizing. Pure copper powder containing 1% impurities (oxygen: 0.5%) and having a particle size of 5 µm was used.

Investigation of the synthesized powder for superconductivity showed a superconductive critical temperature (Tc) of approximately 88 K.

EXAMPLE 12

A powder mixture of raw materials adjusted and mixed so as to give the same blending ratios as in Example 11 was used, and subjected to self-propagating high-temperature synthesis at room temperature in a mixed gas of pure oxygen and argon gas under an absolute pressure of 2,000 kg/cm$^2$ (oxygen partial pressure: 400 kg/cm$^2$). A horizontal refractory crucible was employed, and filled with the powder mixture of raw materials in an amount of 600 g. Ignition was performed by bringing a nichrome wire formed into a coil shape closer to the upper portion of the powder mixture of raw materials and heating it through energizing. Pure copper powder containing 1% impurities (oxygen : 0.5%) and having a particle size of 0.3 µm was used.

Investigation of the synthesized powder for superconductivity showed a superconductive critical temperature (Tc) of approximately 88 K.

[Manufacture of bismuth type oxide superconductive material)

EXAMPLE 13

Raw materials other than oxygen were mixed at accurate blending ratios so as to give $Bi_2Sr_2Ca_2Cu_3O_{10}$, and the resultant mixture was subjected to self-propagating high-temperature synthesis at room temperature in pure oxygen gas under an absolute pressure of 10 kg/cm$^2$. Pure copper containing 1% impurities (oxygen: 0.5%) and having a particle size of 5 µm was used. A refractory crucible with the bottom made of permeable ceramics was employed as a container, and was filled with the powder mixture of raw materials in an amount of 200 g. Ignition was performed by bringing a nichrome wire formed into a coil shape closer to the upper portion of the powder mixture of raw materials and heating it through energizing.

Investigation of the synthesized powder for superconductivity showed a superconductive critical temperature (Tc) of approximately 80 K. The powder was fully sintered at a temperature of 870°C for 20 hours without grinding and calcination, resulting in a superconductive critical temperature (Tc) of 110 K.

EXAMPLE 14

Powder containing 1% impurities (oxygen: 0.5%) and having a particle size of 0.3 µm was mixed and adjusted to the same blending ratios as in Example 13, and subjected to self-propagating high-temperature synthesis in pure oxygen gas under an absolute pressure of 100 kg/cm$^2$. A crucible made of permeable ceramics was employed, and filled with the powder mixture of raw materials in an amount of 400 g. Ignition was performed by bringing a nichrome wire formed into a coil shape closer to the upper portion of the powder mixture of raw materials and heating it through energizing.

Investigation of the synthesized powder for superconductivity showed a superconductive critical temperature (Tc) of approximately 110 K as shown in Fig. 5.

[Manufacture of thallium the oxide superconductive materials]

EXAMPLE 15

Raw materials other than oxygen were mixed at accurate blending ratios so as to give $TlBa_2Ca_2Cu_3O_9$, and subjected to self-propagating high-temperature synthesis at room temperature in pure oxygen under an absolute pressure of 100 kg/cm$^2$. A crucible made of permeable ceramics was employed, and was filled with the powder mixture of raw materials in an amount of 200 g. Ignition was performed by bringing a nichrome wire formed into a coil shape closer to the upper portion of the powder mixture of raw materials and heating it through energizing.

Investigation of the synthesized powder for superconductivity showed a superconductive critical temperature (Tc) of approximately 123 K as shown in Fig. 6.

It is needless to mention that the present invention is not limited to these examples, but various variations of the details of structure and configuration of the apparatus are possible.

## Claims

1. A method of manufacturing an oxide superconductive material containing copper and oxygen as component elements, which method comprises introducing external heat input to a portion of a powder mixture comprising substantially pure copper powder and powder of pure metals or compounds of other component elements, causing a synthetic combustion reaction in said portion between said copper powder and gaseous oxygen whereby the heat of combustion produced in said reaction causes propagation of said synthetic combustion reaction throughout the entire powder mixture by self-propagating high temperature synthesis.

2. A method as claimed in claim 1 wherein said copper powder has a content of oxygen and other impurities of up to 3% and an average particle size of up to 50 $\mu m$.

3. A method as claimed in claim 1 or claim 2 wherein said gaseous oxygen is substantially pure oxygen gas or a mixture of substantially pure oxygen gas and an inert gas under an absolute gas pressure of greater than 0.1 $kg/cm^2$.

4. A method as claimed in any one of the preceding claims wherein said powder mixture is present in a refractory crucible, a permeable refractory crucible, a refractory net, a crucible with the bottom comprising a refractory net or permeable ceramics, or a horizontal crucible or a U-shaped crucible.

5. A method as claimed in any one of the preceding claims wherein said powder mixture is ignited by the energizing and heating of a resistance wire, the application of electric energy, or heating in an electric furnace.

6. An apparatus for manufacturing an oxide superconductive material as claimed in claim 1, said apparatus comprising a structure having a resistance wire, a means for applying electric energy, or an electric furnace, whereby to ignite a powder mixture as defined in claim 1.

7. An oxide superconductive material prepared by a method as claimed in any one of claims 1 to 5.

Fig.1

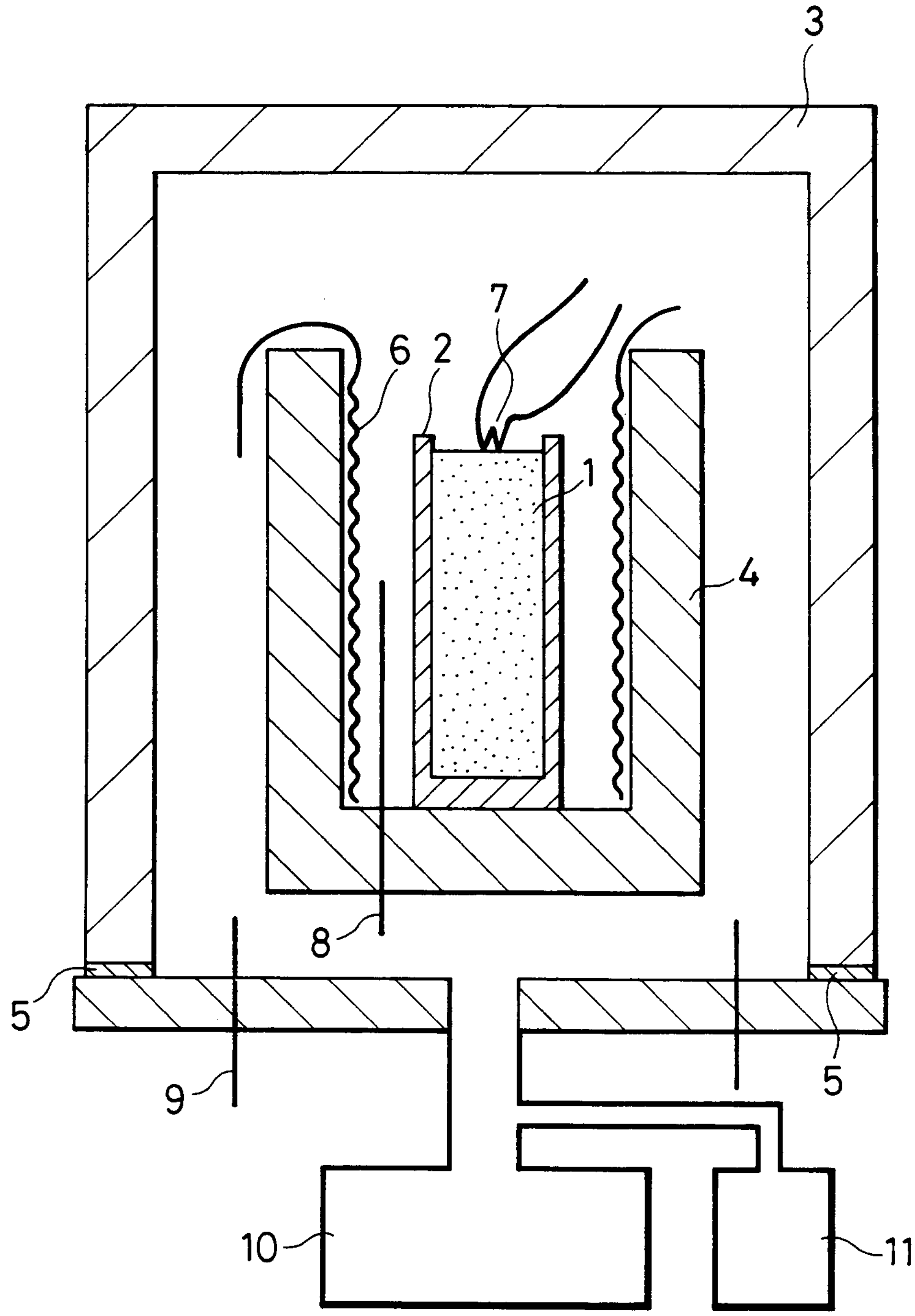

Fig.2(a)

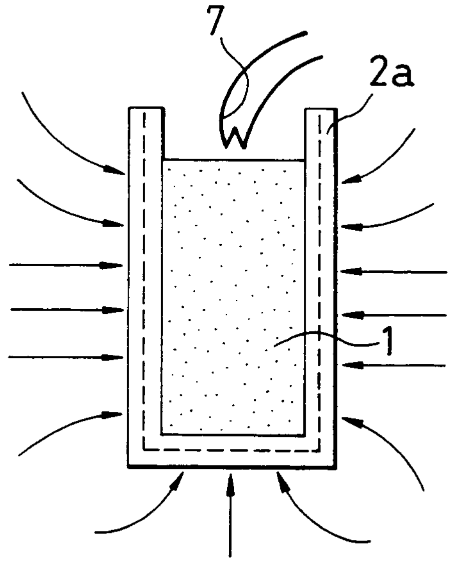


Fig.2(b)

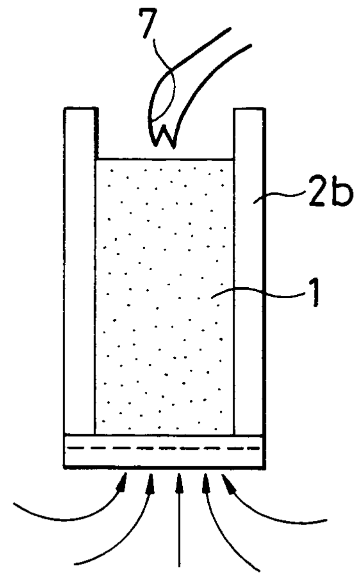


Fig.2(c)

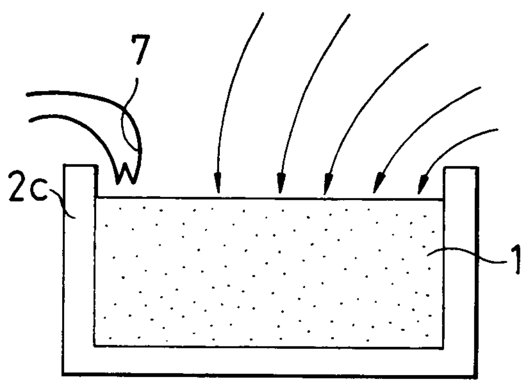


Fig.2(d)

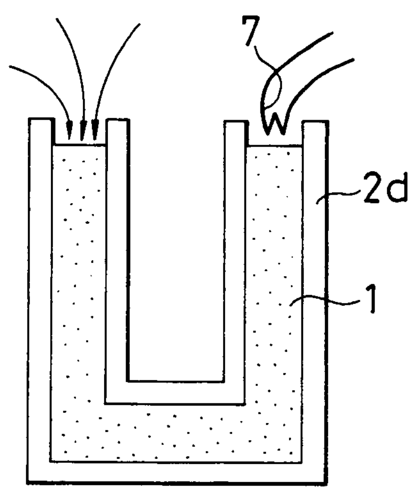

Fig.3

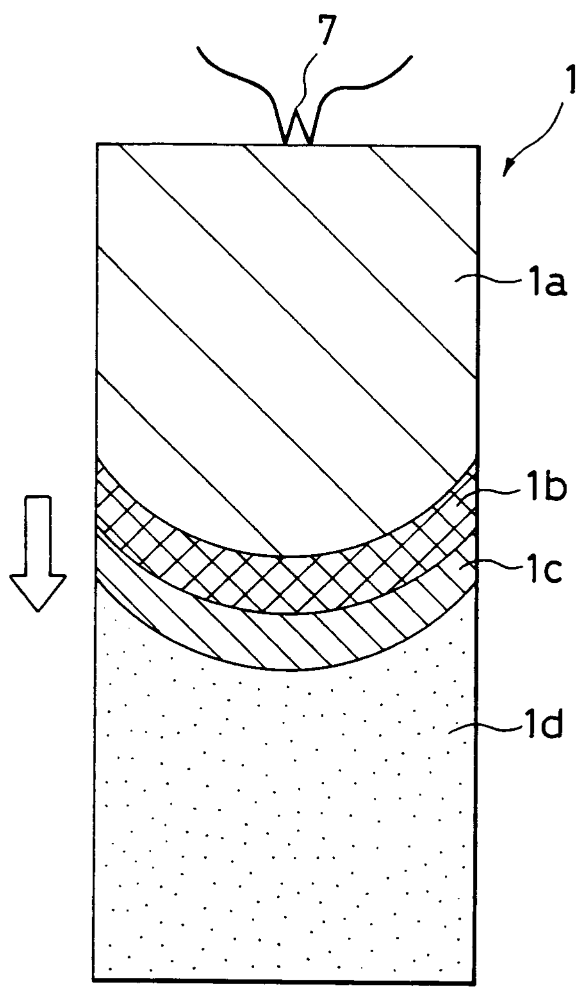

Fig.4

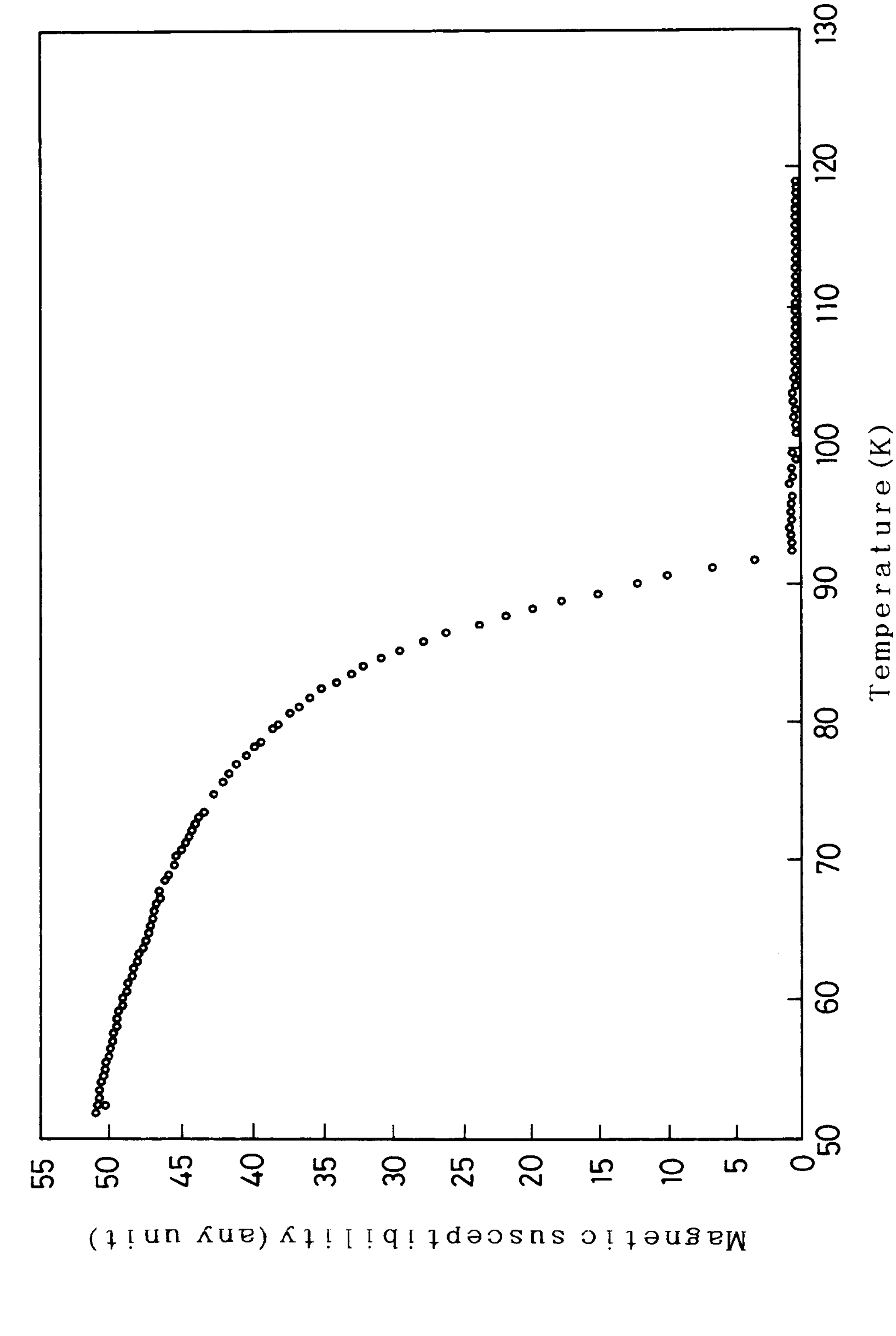
Magnetic susceptibility (any unit)
55
50
45
40
35
30
25
20
15
10
5
0
50
60
70
80
90
100
110
120
130
Temperature (K)

Fig. 5

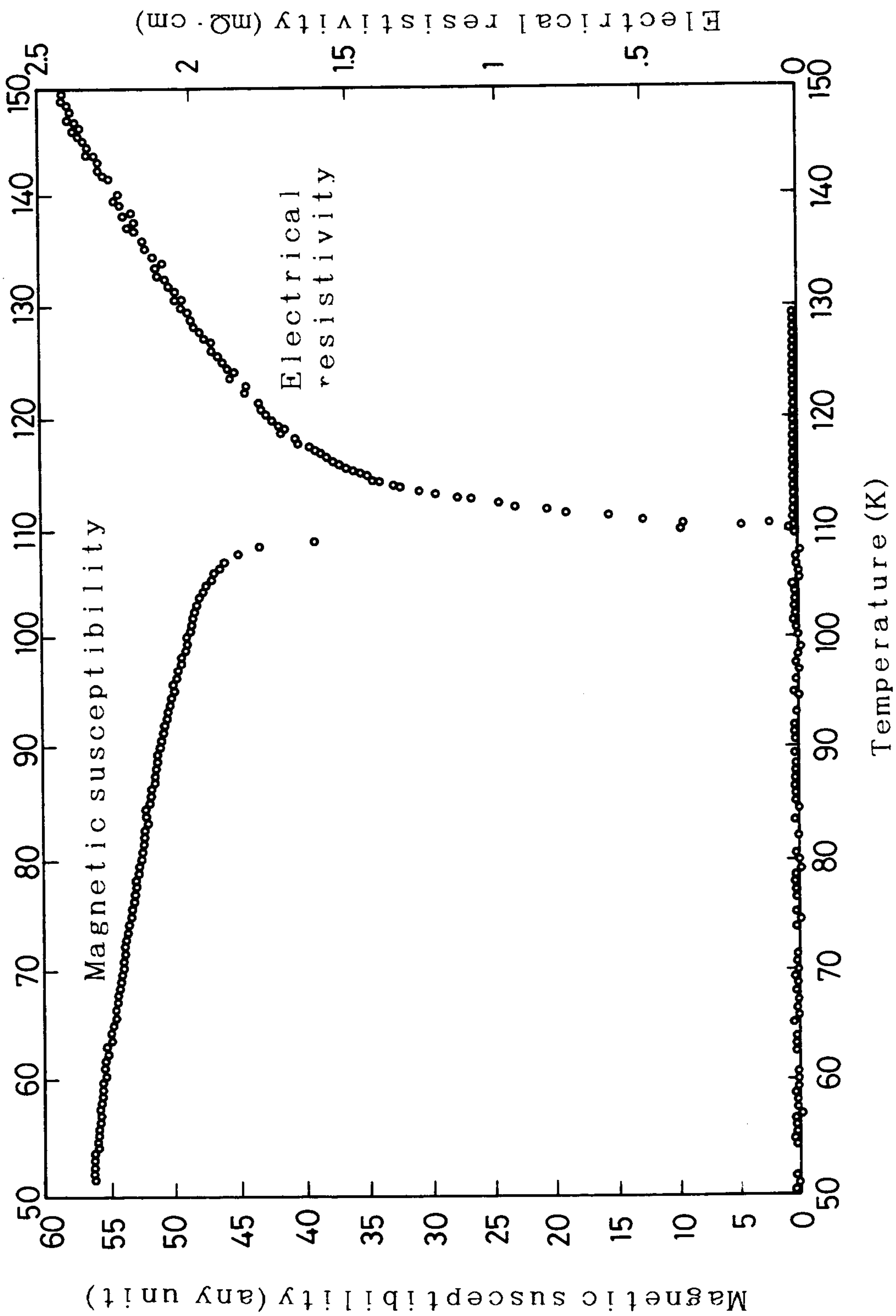
Magnetic susceptibility (any unit)
Electrical resistivity (mΩ · cm)
Temperature (K)
Magnetic susceptibility
Electrical resistivity
50
60
70
80
90
100
110
120
130
140
150
0
5
10
15
20
25
30
35
40
45
50
55
60
.5
1
1.5
2
2.5

Fig.6

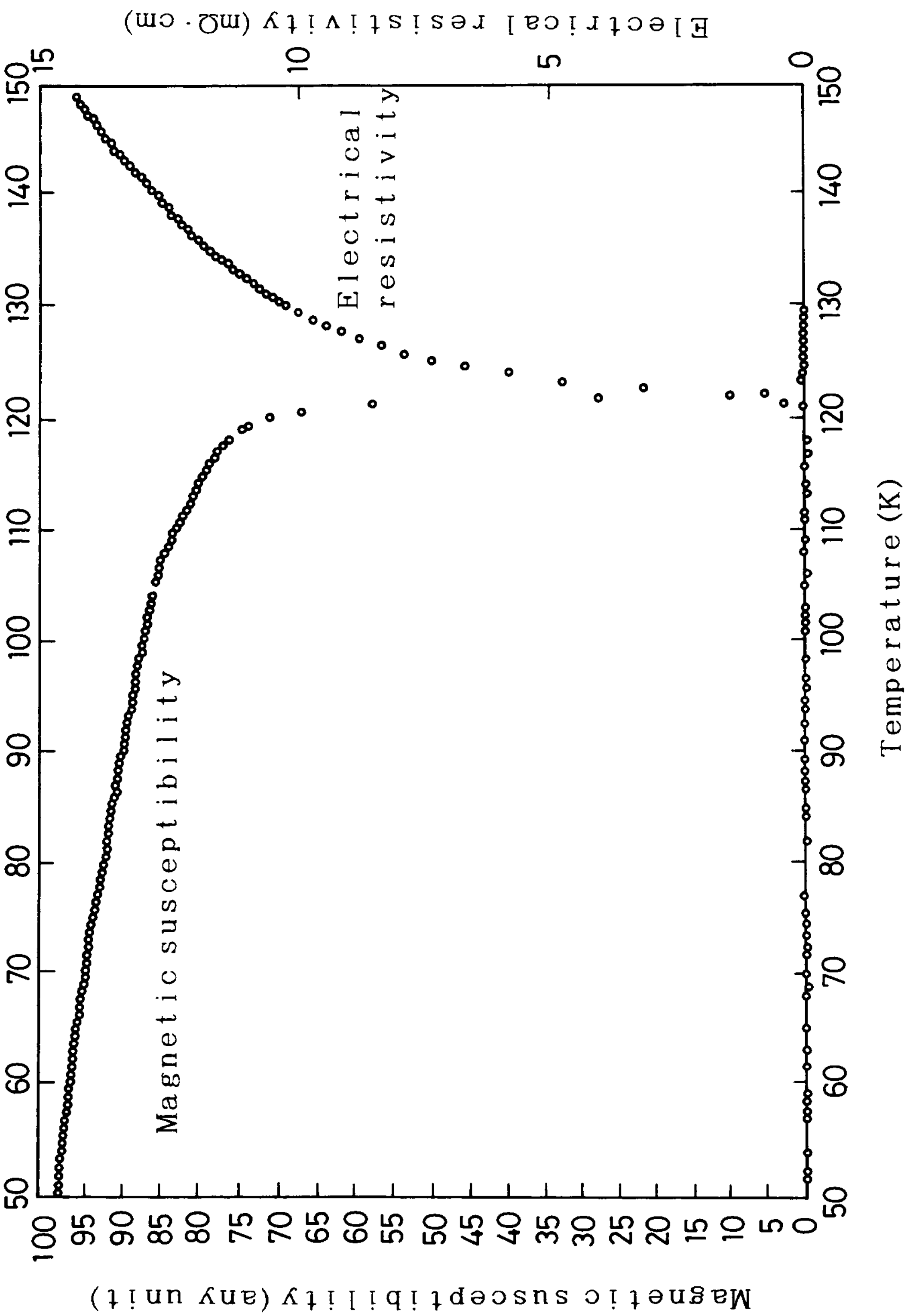
Electrical resistivity (mΩ·cm)
Electrical resistivity
Magnetic susceptibility
Magnetic susceptibility (any unit)
Temperature (K)